# EUROPÄISCHE PATENTSCHRIFT

(11) **EP 0 555 518 B1**
(45) Veröffentlichungstag und Bekanntmachung des Hinweises auf die Patenterteilung: **08.01.1997**
(21) Anmeldenummer: 92113074.6
(22) Anmeldetag: 31.07.1992
(51) Int. Cl.: C23C 14/58, C23C 14/56, C23C 14/10

(54) **Verfahren für die Behandlung einer Oxidschicht**
Method for treating an oxide layer
Procédé pour le traitement d'une couche d'oxyde

(30) Priorität: 08.02.1992 DE 4203631
(43) Veröffentlichungstag der Anmeldung: 18.08.1993
(73) Patentinhaber: Balzers und Leybold Deutschland Holding Aktiengesellschaft, 63450 Hanau (DE); Toppan Printing Co., Ltd., Taito-ku Tokyo (JP)
(72) Erfinder: Krug, Thomas, Dr., W-6450 Hanau 1 (DE); Rübsam, Klemens, Dipl.-Phys., W-6485 Jossgrund (DE); Meier, Andreas, Dipl.-Phys., W-7417 Pfullingen (DE); Steiniger, Gerhard, Dipl.-Phys., W-6451 Ronneburg (DE); Kano,Mitsuru, Shinjuku-ku Tokyo (JP); Sasaki,Noboru, Kitakatushika-Gun Saitama (JP); Miyamoto,Takashi, Kitakatushika-Gun Saitama (JP); Sekiguchi,Mamoru, Kawaguchi-shi Saitama (JP)
(74) Vertreter: Schickedanz, Willi, Dipl.-Ing.

(56) Entgegenhaltungen:
- EP-A- 0 041 850
- EP-A- 0 460 796
- US-A- 4 740 385
- PATENT ABSTRACTS OF JAPAN vol. 6, no. 49 (C-96)(927) 31. März 1982

## Beschreibung

Die Erfindung betrifft ein Verfahren nach dem Oberbegriff des Patentanspruchs 1.

Auf Kunststoffe, insbesondere auf klarsichtige Kunststoffe werden oft dünne Schichten aufgebracht, um negative Eigenschaften dieser Kunststoffe zu kompensieren oder um neue Eigenschaften hinzuzufügen.

Eine negative Eigenschaft von Kunststoffolien ist die Durchlässigkeit für Gase und Wasserdampf. Zwar hat es den Anschein, als seien derartige Folien absolut dicht, doch hat sich herausgestellt, daß durch sie erhebliche Mengen von Molekülen diffundieren können. Werden derartige Folien als Verpackungsmaterial für Lebensmittel verwendet, so stellt diese Eigenschaft einen erheblichen Mangel dar, weil im Laufe der Zeit Sauerstoff in die Verpackung gelangt und Aromastoffe entweichen können.

Es ist bereits bekannt, auf Kunststoffolien eine zusätzliche Barriere gegen die Diffusion von O₂, H₂O oder Aromastoffen aufzubringen (T. Krug, K. Rübsam: Die neue "gläserne" Lebensmittelverpackung" in "neue verpackung", Hüthig-Verlag, 1991). Eine solche transparente und mikrowellendurchlässige Barriere wird durch Aufdampfen von SiO erreicht.

Ein Nachteil dieser Beschichtung ist jedoch ihre leicht gelbliche Farbe aufgrund der Absorption von Licht der Wellenlängen unterhalb von ca. 450 nm. Dieser Gelbton läßt viele Waren unansehnlich erscheinen.

Weiterhin ist ein Verfahren für die Herstellung von Audio- und Videomagnetbändern bekannt, bei dem ein Kunststoffband mit elektrisch leitendem Material beschichtet wird, beispielsweise mit einer Kobalt-Nickel-Legierung (US-A-4 740 385). Für die Behandlung von Oxidschichten ist dieses Verfahren nicht vorgesehen.

Bei einem anderen bekannten Verfahren für die Bildung einer Schicht auf einer Folie wird die Folie in einer ersten Kammer mit verdampftem Metall beaufschlagt und dann in einer zweiten Kammer einem Plasma ausgesetzt (Patent Abstracts of Japan, Vol. 6, No. 49 (C-96) (927), 31. März 1982, bzw. JP-A-56163 262, 15.12.1981). Die zweite Kammer wird mittels einer Pumpe evakuiert, so daß eine inerte Gasatmosphäre zwischen zwei Elektrodenplatten entsteht, zwischen denen die Folie durchläuft. Die Oberfläche der beschichteten Folie wird hierbei mit einem einheitlichen und dichten Oxid- oder Nitridfilm versehen. Eine Nachbehandlung dieses Oxid- oder Nitridfilms erfolgt jedoch nicht.

Schließlich ist auch noch eine Polymer-Folie bekannt, die eine Sperrschicht gegen Sauerstoff und andere Materialien aufweist (EP-A-0 460 796). Diese Folie wird insbesondere zu Verpackungszwecken verwendet. Sie weist eine SiO-Schicht mit einer darauf liegenden SiO₂-Schicht auf. Obgleich die SiO₂-Schicht mit metallischem Material gedopt sein kann, ist sie farblos, so daß auch die gesamte Mehrschicht-Struktur farblos ist. Ein Verfahren, mit dem eine nicht ganz klarsichtige Folie nachbehandelt wird, kommt hierbei nicht zum Einsatz.

Der Erfindung liegt deshalb die Aufgabe zugrunde, ein bereits beschichtetes Substrat so zu behandeln, daß es die gewünschte Farbe annimmt.

Diese Aufgabe wird gemäß den Merkmalen des Patentanspruchs 1 gelöst.

Der mit der Erfindung erzielte Vorteil besteht insbesondere darin, daß die Transmission der Beschichtung einer Klarsichtfolie im Wellenlängenbereich von 450 nm und weniger erhöht wird, ohne daß die Barrierewirkung der SiO-Schicht gegen Sauerstoff, Wasser und Aromastoffe verschlechtert wird. Außerdem ist es möglich, bei anderen Schichten auf Folien, z. B. bei Schichten aus MgO oder Al₂O₃, die auf einer Sauerstoffunterstöchiometrie beruhenden Farbeffekte zu eliminieren.

Ein Ausführungsbeispiel der Erfindung ist in der Zeichnung dargestellt und wird im folgenden näher beschrieben. Es zeigen:
- Fig. 1: eine schematische Darstellung einer erfindungsgemäßen Behandlung einer mit Metalloxid beschichteten Folie;
- Fig. 2: eine schematische Darstellung einer Vorrichtung, mit der eine Folie beschichtet und anschließend mittels eines Plasmas behandelt wird.

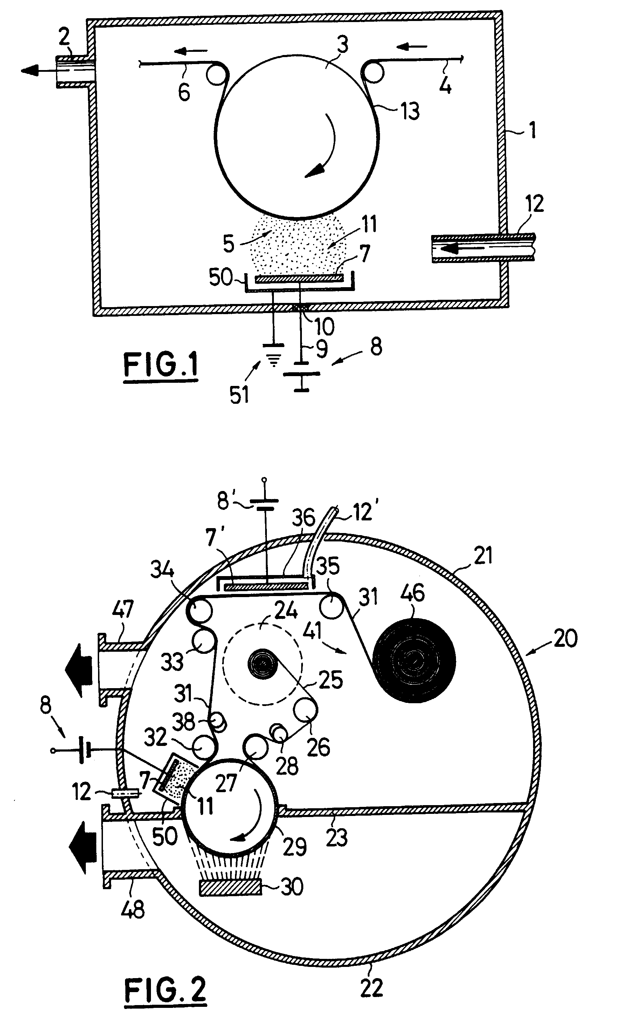

In der Fig. 1 ist eine schematische Darstellung einer Vorrichtung gezeigt, mit der eine bereits mit einer SiO-Schicht versehene Kunststoffolie nachbehandelt wird. In einem Behälter 1, der über einen Absaugstutzen 2 auf etwa 10⁻² bis 10⁻³ mbar evakuiert wird, befindet sich eine Umlenkwalze 3, die eine von einer nicht dargestellten Abwickelwalze ankommende Folie 4 in einen Bereich 5 nach unten umlenkt, von dem aus diese wieder nach oben gelenkt und als abgehende Folie 6 einer nicht dargestellten Aufwickelwalze zugefführt wird. Gegenüber dem Bereich 5 ist eine Kathode 7 angeordnet, die mit dem negativen Pol einer Gleichspannungsquelle 8 verbunden ist. Eine elektrische Zuführungsleitung 9 von der Spannungsquelle 8 zur Elektrode 7 ist durch eine Isolierung 10 im Behälter 1 geführt Unterhalb der Kathode 7 befindet sich eine geerdete Dunkelraumabschirmung 50, die verhindert, daß sich ein Plasma zwischen der Kathode 7 und dem Behälter 1 ausbildet.

Wird die Elektrode 7 an negatives Potential gelegt, so bildet sich zwischen dem Bereich 5 und der Elektrode 7 ein Plasma 11 aus. Dieses Plasma besteht aus einem Sauerstoff-Argon-Gemisch oder aus einem Wasserstoff-Argon-Gemisch, das über einen Einführstutzen 12 in den Behälter 1 eingeführt wird. Statt einer einfachen Kathode 7 könnte auch eine Magnetronkathode zum Einsatz kommen.

Eine dünne SiO-Schicht, die sich auf der Folie 4 befindet, wird durch das Plasma 11 derart beeinflußt, daß eine SiOₓ-Schicht entsteht, wobei x zwischen 1 und 2 liegt, vorzugsweise jedoch zwischen 1 und 1,5. Diese Schichtbeeinflussung und -veränderung erfolgt durch Beschuß von ionisierten oder angeregten Atomen und von Elektronen aus dem Plasma 11. Hierdurch wird Sauerstoff in die Schicht eingebracht, was deren Struktur beeinflußt. Insbesondere angeregte und ionisierte Sauerstoffatome können in die SiO-Schicht eindiffundieren.

Anstelle einer SiOₓ-Schicht 13 könnte auf der Folie 4 auch eine MgO- oder Al₂O₃-Schicht vorgesehen sein. Diese könnte dann, wenn durch den Stutzen 12 eine Argon-Sauerstoff-Mischung in den Behälter 1 eingelassen wird, aufgehellt werden, sofern sie wegen einer Unterstöchiometrie Farbeffekte zeigt.

In der Fig. 2 ist eine Vorrichtung gezeigt, mit der eine Folie zunächst mit SiOₓ beschichtet und sodann mit einer Anordnung gemäß Fig. 1 nachbehandelt wird. Ein Gehäuse 20 ist hierbei in zwei Kammern 21, 22 unterteilt, die durch eine Wand 23 voneinander getrennt sind In der oberen Kammer 21 befindet sich eine Abwickelwalze 24, von der eine unbeschichtete und bandförmige Folie 25 über Umlenkwalzen 26, 27 und eine Tänzerwalze 28 einer Beschichtungswalze 29 zugeführt ist.

Gegenüber der Beschichtungswalze 29 ist ein Tiegel 30 angeordnet, in dem sich ein Beschichtungsmaterial befindet, z. B. SiO. Dieses SiO wird durch einen Ofen oder durch einen Elektronenstrahl verdampft und schlägt sich auf der Folie 25 als dünne SiOₓ-Schicht nieder. Der notwendige Sauerstoff, um das Ausgangsmaterial SiOₓ (x = 1) hochzuoxidieren (1,5 ≤ x ≤ 1,7), stammt von desorbierendem Wasserdampf von der Folie. Dieser Wasserdampf wird durch die hohen Temperaturen thermisch zu Wasserstoff und Sauerstoff zerlegt. In den Zwischenraum zwischen Tiegel 30 und Walze 29 können noch Mikrowellen eingegeben werden, um die Eigenschaften der Schicht 31 zu verbessern.

Nachdem die Folie 25 beschichtet wurde, läuft sie an einer Kathode 7 vorbei, die sich in der Kammer 21 befindet. Zwischen dieser Kathode 7 und der beschichteten Folie liegt ein Plasma 11, durch das die Beschichtung auf der Folie nachbehandelt wird. In der oberen Kammer 21 herrscht in diesem Fall ein Druck von etwa 10⁻² mbar, während in der unteren Kammer 22 ein Druck von 10⁻⁴ bis 10⁻³ mbar herrscht. Über Umlenkwalzen 32 bis 35 und eine Tänzerwalze 38 wird die behandelte Folie 31 auf eine Aufwickelwalze 46 gewickelt.

Die Kathode 7 kann auch an einer anderen Stelle angeordnet sein, die mit der Bezugszahl 7' bezeichnet ist. Diese zwischen den Walzen 34 und 35 angeordnete Elektrode 7' kann mit einem eigenen Gehäuse 36 umgeben sein, in welches Gas eingegeben wird. Der Druck von 10⁻² mbar braucht dann nur innerhalb des Gehäuses 36 aufrechterhalten zu werden.

## Patentansprüche

1. Verfahren für die Behandlung einer Oxidschicht auf einer Folie (4, 25), um das farbliche Aussehen dieser Oxidschicht zu ändern, **gekennzeichnet durch** folgende Schritte:
a) Anordnen einer Glühkathode (7, 7') gegenüber der Oxidschicht der Folie (4, 25)
b) Bewegen der Folie (4, 25) relativ zur Glühkathode (7, 7')
c) Bereitstellen eines Gases, das reaktives Gas enthält, zwischen der Glühkathode (7, 7') und der Oxidschicht der Kunststoff-Folie (4, 25),
d) Erzeugen eines Plasmas mittels der Glühkathode (7, 7'), wobei dieses Plasma das reaktive Gas enthält,
e) Behandeln der Oxidschicht mittels des Plasmas.

2. Verfahren nach Anspruch 1, **dadurch gekennzeichnet,** daß die Oxidschicht eine SiOₓ-Schicht ist, wobei 1,5 ≤ x ≤ 1,7 gilt.

3. Verfahren nach Anspruch 1, **dadurch gekennzeichnet,** daß die Folie eine Kunststoff-Folie (4, 25) ist.

4. Verfahren nach Anspruch 1, **dadurch gekennzeichnet,** daß dem reaktiven Gas ein inertes Gas beigemischt ist.

5. Verfahren nach Anspruch 1, **dadurch gekennzeichnet,** daß das reaktive Gas Sauerstoff ist.

6. Verfahren nach Anspruch 1, **dadurch gekennzeichnet,** daß das reaktive Gas H₂ ist.

7. Verfahren nach Anspruch 4, **dadurch gekennzeichnet,** daß das Inertgas Argon ist.

8. Verfahren nach Anspruch 1 oder Anspruch 4, **dadurch gekennzeichnet,** daß das reaktive Gas oder das Gemisch aus inertem und reaktivem Gas unter einem Druck von 10⁻¹ bis 10⁻³ mbar steht.

9. Verfahren nach Anspruch 1, **dadurch gekennzeichnet,** daß die Glühkathode (7, 7') eine metallische Kathode ist.

10. Verfahren nach Anspruch 1, **dadurch gekennzeichnet,** daß die Glühkathode eine Magnetron-Kathode ist.

11. Verfahren nach Anspruch 1, **dadurch gekennzeichnet,** daß das Bewegen der Folie (4, 25) mittels einer Abwickelwalze (24) und einer Aufwickelwalze (46) erfolgt.

12. Verfahren nach Anspruch 11, **dadurch gekennzeichnet,** daß die Folie (4, 25) zwischen Abwickelwalze (24) und Aufwickelwalze (46) durch Umlenkrollen (32 bis 35) geführt wird.

13. Verfahren nach Anspruch 1, **dadurch gekennzeichnet,** daß eine Vorrichtung (29, 30) bereitgestellt wird, mit welcher die Folie (25) mit einer Oxidbeschichtung (31) versehen wird.

14. Verfahren nach Anspruch 1, **dadurch gekennzeichnet,** daß
a) ein Behälter (30) bereitgestellt wird, in dem sich ein zu verdampfendes Material befindet;
b) eine Verdampfungsvorrichtung bereitgestellt wird, die das Material in dem Behälter (30) verdampft;
c) das zu beschichtende Material (25) in einem Abstand von dem zu verdampfenden Material angeordnet ist.

15. Verfahren nach Anspruch 14, **dadurch gekennzeichnet,** daß ein Mikrowellensender bereitgestellt wird, der Mikrowellen in den Raum zwischen dem zu verdampfenden Material und dem zu beschichtenden Material sendet.

## Claims

1. Process for treatment of an oxide layer on a film (4, 25) in order to change the colouring of this oxide layer, **characterized by** the following steps:
a) positioning of a hot cathode (7, 7') opposite the oxide layer of the film (4, 25)
b) movement of the film (4, 25) relative to the hot cathode (7, 7')
c) provision of a gas which comprises reactive gas between the hot cathode (7, 7') and the oxide layer of the film (4, 25) of plastic
d) generation of a plasma by means of the hot cathode (7, 7'), this plasma comprising the reactive gas
e) treatment of the oxide layer by means of the plasma.

2. Process according to claim 1, **characterized in that** the oxide layer is an SiOₓ layer, wherein 1.5 ≤ x ≤ 1.7.

3. Process according to claim 1, **characterized in that** the film is a film (4, 25) of plastic.

4. Process according to claim 1, **characterized in that** an inert gas is admixed to the reactive gas.

5. Process according to claim 1, **characterized in that** the reactive gas is oxygen.

6. Process according to claim 1, **characterized in that** the reactive gas is H₂.

7. Process according to claim 4, **characterized in that** the inert gas is argon.

8. Process according to claim 1 or claim 4, **characterized in that** the reactive gas or the mixture of inert and reactive gas is under a pressure of 10⁻¹ to 10⁻³ mbar.

9. Process according to claim 1, **characterized in that** the hot cathode (7, 7') is a metallic cathode.

10. Process according to claim 1, **characterized in that** the hot cathode is a magnetron cathode.

11. Process according to claim 1, **characterized in that** the movement of the film (4, 25) is effected by means of an unwinding roll (24) and a winding-up roll (46).

12. Process according to claim 11, **characterized in that** the film (4, 25) is guided between the unwinding roll (24) and the winding-up roll (46) by deflection rolls (32 to 35).

13. Process according to claim 1, **characterized in that** a device (29, 30) with which the film (25) is given an oxide coating (31) is provided.

14. Process according to claim 1, **characterized in that**
a) a container (30) which contains a material to be vaporized is provided;
b) a vaporization device which vaporizes the material in the container (30) is provided;
c) the material (25) to be coated is positioned at a distance from the material to be vaporized.

15. Process according to claim 14, **characterized in that** a microwave emitter which emits microwaves into the space between the material to be vaporized and the material to be coated is provided.

## Revendications

1. Procédé pour le traitement d'une couche d'oxyde sur une feuille (4, 25) pour modifier l'apparence de couleur de cette couche d'oxyde, caractérisé par les étapes suivantes :
a) disposition d'une cathode thermo-ionique (7, 7') en face de la couche d'oxyde de la feuille (4, 25),
b) déplacement de la feuille (4, 25) par rapport à la cathode thermo-ionique (7, 7')
c) mise à disposition d'un gaz qui contient du gaz réactif entre la cathode thermo-ionique (7, 7') et la couche d'oxyde de la feuille en matière plastique (4, 25),
d) génération d'un plasma au moyen de la cathode thermo-ionique (7, 7'), ce plasma contenant le gaz réactif,
e) traitement de la couche d'oxyde au moyen du plasma.

2. Procédé selon la revendication 1, caractérisé en ce que la couche d'oxyde est une couche de SiOₓ, où s'applique 1,5 ≤ x ≤ 1,7.

3. Procédé selon la revendication 1, caractérisé en ce que la feuille est une feuille en matière plastique (4, 25).

4. Procédé selon la revendication 1, caractérisé en ce que le gaz réactif est mélangé à un gaz inerte.

5. Procédé selon la revendication 1, caractérisé en ce que le gaz réactif est de l'oxygène.

6. Procédé selon la revendication 1, caractérisé en ce que le gaz réactif est du H₂.

7. Procédé selon la revendication 4, caractérisé en ce que le gaz inerte est de l'argon.

8. Procédé selon la revendication 1 ou la revendication 4, caractérisé en ce que le gaz réactif ou le mélange du gaz réactif et du gaz inerte subit une pression de 10⁻¹ à 10⁻³.

9. Procédé selon la revendication 1, caractérisé en ce que la cathode thermo-ionique (7, 7') est une cathode métallique.

10. Procédé selon la revendication 1, caractérisé en ce que la cathode thermo-ionique est une cathode de magnétron.

11. Procédé selon la revendication 1, caractérisé en ce que le déplacement de la feuille (4, 25) s'effectue à l'aide d'un cylindre de déroulement (24) et d'un cylindre d'enroulement (46).

12. Procédé selon la revendication 11, caractérisé en ce que la feuille (4, 25) est guidée entre le cylindre de déroulement (24) et le cylindre d'enroulement (46) par le biais de poulies de renvoi (32 à 35).

13. Procédé selon la revendication 1, caractérisé en ce qu'il est prévu un dispositif (29, 30) par lequel la feuille (25) est munie d'un revêtement d'oxyde (31).

14. Procédé selon la revendication 1, caractérisé en ce que
a) un récipient (30) est prévu dans lequel se trouve la matière d'évaporation ;
b) un dispositif d'évaporation est prévu qui évapore la matière dans le récipient (30) ;
c) la matière (25), à recouvrir d'une couche, est disposée à distance de la matière à évaporer.

15. Procédé selon la revendication 14, caractérisé en ce qu'un émetteur de micro-ondes est prévu qui envoie des micro-ondes dans l'espace entre la matière d'évaporation et la matière à recouvrir d'une couche.
